# DEMANDE DE BREVET EUROPEEN

(11) **EP 2 731 141 A1**
(43) Date de publication de la demande: **14.05.2014**
(21) Numéro de dépôt: 13354041.9
(22) Date de dépôt: 05.11.2013
(51) Int. Cl.: H01L 29/66, H01L 29/786, H01L 21/265, H01L 21/266

(54) **Procédé de réalisation d'un transistor à effet de champ à canal SiGe par implantation ionique**

(30) Priorité: 07.11.2012 FR 1202981
(71) Demandeur: COMMISSARIAT A L'ENERGIE ATOMIQUE ET AUX ENERGIES ALTERNATIVES, 75015 Paris (FR)
(72) Inventeur: Grenouillet, Laurent, F-38140 Rives (FR); Vinet, Maud, F-38140 Rives (FR); LE Tiec, Yannick, F-38920 Crolles (FR); Wacquez, Romain, F-13008 Marseille (FR); Faynot, Olivier, F-38170 Seyssinet-Pariset (FR)
(74) Mandataire: Talbot, Alexandre

(57) **Abrégé**

Le substrat de type semi-conducteur sur isolant comporte un support (1), un film électriquement isolant (2), un film cristallin en matériau semi-conducteur (3), une couche de protection (4). Des ions de germanium sont implantés dans le film en matériau semi-conducteur (3) à travers la couche de protection (4) de manière à former une zone amorphisée en contact avec la couche de protection (4) et une zone cristalline en contact avec le film électriquement isolant (2). Le film en matériau semi-conducteur (3) est recuit de manière à recristalliser la zone amorphisée à partir de la zone cristalline.

## Description

### Domaine technique de l'invention

L'invention est relative à un procédé de réalisation d'un film en silicium-germanium pour dispositif à effet de champ.

### État de la technique

L'augmentation continue des performances des circuits intégrés, par exemple, en termes de consommation et/ou de fréquence de fonctionnement, se traduit inéluctablement par une diminution constante de la taille de ses composants. Afin de réaliser des dispositifs toujours plus performants, de nouvelles architectures et/ou de nouveaux matériaux ont été intégrés dans les transistors.

La technologie microélectronique actuelle, basée sur le silicium, arrive aux limites des possibilités offertes par ce matériau. Les besoins croissants en dispositifs électroniques toujours plus performants, plus rapides et plus économes en énergie ont conduit à étudier de nouvelles solutions.

En comparaison du silicium, le germanium pur présente une mobilité deux fois plus importante pour les électrons et quatre fois plus importante pour les trous. L'inconvénient des transistors en germanium est le coût du substrat qui est environ 10 fois plus élevé que celui d'un substrat de silicium massif. De plus, il est très difficile de former des canaux en germanium pur par épitaxie de germanium de bonne qualité sur un substrat de silicium. Une des solution est de former un canal en alliage de silicium-germanium afin d'accroitre les performance du transistor sans avoir les inconvénients du germanium pur.

Une application particulière concerne les transistors à effet de champ de type p (pMOSFET : « metal-oxyde-semiconductor field-effect transistor). L'article « Selectively-formed high mobility SiGe-On-Insulator pMOSFETs with Ge-rich strained surface channels using local condensation technique » de T. Tezuka et al. (2004 IEEE Symposium on VLSI Technology Digest of technical papers) décrit notamment la réalisation d'un pMOSFET, dont l'amélioration des performances est particulièrement sensible pour des transistors appauvris en porteurs de charge (FD pMOSFET) réalisés en germanium.

Cependant, cette technique est particulièrement difficile à mettre en oeuvre pour les substrats de type semi-conducteur sur isolant avec des films mince. La température appliquée pour obtenir la diffusion des atomes de germanium dans le film semi-conducteur entraine également une modification de la configuration du substrat. Les modifications du substrat sont d'autant plus importantes que les épaisseurs sont fines.

Un problème majeur de la technique de condensation germanium, pour la fabrication d'un substrat comprenant un composé en Si_{1-Xf}Ge_{Xf}, est la relaxation des contraintes dans la couche finale enrichie en germanium. Lors de l'oxydation de la couche en Si_{1-Xi}Ge_{Xi}, il y a compétition entre oxydation du silicium et diffusion du germanium. Un fort gradient de composition peut conduire à un état de contrainte locale, tel que la couche se relaxe plastiquement. Il en résulte alors l'apparition de réseaux croisés de dislocations dans la couche finale, engendrant notamment une mauvaise qualité du substrat.

Une manière de contourner ce problème réside dans l'implantation d'atomes de germanium dans le film semi-conducteur sur isolant. Cependant, l'implantation de germanium ne permet pas de réaliser, de manière fiable et industrielle, un film en silicium-germanium sur isolant.

En effet, il est nécessaire d'implanter une grande quantité d'ions germanium afin de transformer un film de silicium en un alliage de silicium-germanium. L'implantation de cette grande quantité d'ions rend le procédé particulièrement sensible au phénomène d'amorphisation du film semi-conducteur qui perd alors son caractère cristallin.

Par ailleurs, pour la formation d'un film mince de silicium-germanium, le procédé d'implantation est particulièrement sensible aux variations d'épaisseurs qui entrainent des variations de performance importantes.

### Objet de l'invention

L'invention a pour objet la réalisation d'un substrat muni d'un film en silicium-germanium qui est plus facile à mettre en oeuvre.

Le procédé selon l'invention est caractérisé en ce qu'il comporte successivement :
- prévoir un substrat de type semi-conducteur sur isolant comportant successivement : un support, un film électriquement isolant, un film cristallin en matériau semi-conducteur, une couche de protection,
- implanter des ions de germanium dans le film en matériau semi-conducteur à travers la couche de protection de manière à former une zone amorphisée en contact avec la couche de protection et une zone cristalline en contact avec le film électriquement isolant,
- recuire le film en matériau semi-conducteur de manière à recristalliser la zone amorphisée à partir de la zone cristalline.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en vue de coupe, une étape de réalisation d'un procédé d'implantation de germanium,
- la figure 2 représente de manière schématique le profil de germanium dans le substrat avec et sans couche de protection,
- les figures 3 et 4 représentent, de manière schématique, en vue de coupe, un mode de réalisation particulier d'un dispositif à effet de champ,
- la figure 5 représente, de manière schématique, en vue de coupe, un mode de réalisation particulier d'une zone en silicium-germanium,
- la figure 6 représente, de manière schématique, en vue de coupe, un autre mode de réalisation particulier d'une zone en silicium-germanium.

### Description de modes de réalisation préférentiels de l'invention

Le procédé de réalisation d'un film en silicium-germanium comporte la fourniture d'un substrat de type semi-conducteur sur isolant. Le substrat comporte successivement un support 1, un film électriquement isolant 2, un film cristallin en matériau semi-conducteur 3 et une couche de protection 4. Le support 1 peut comporter plusieurs couches réalisées dans des matériaux différents. Le film électriquement isolant 2 est réalisé dans un matériau différent du support 1.

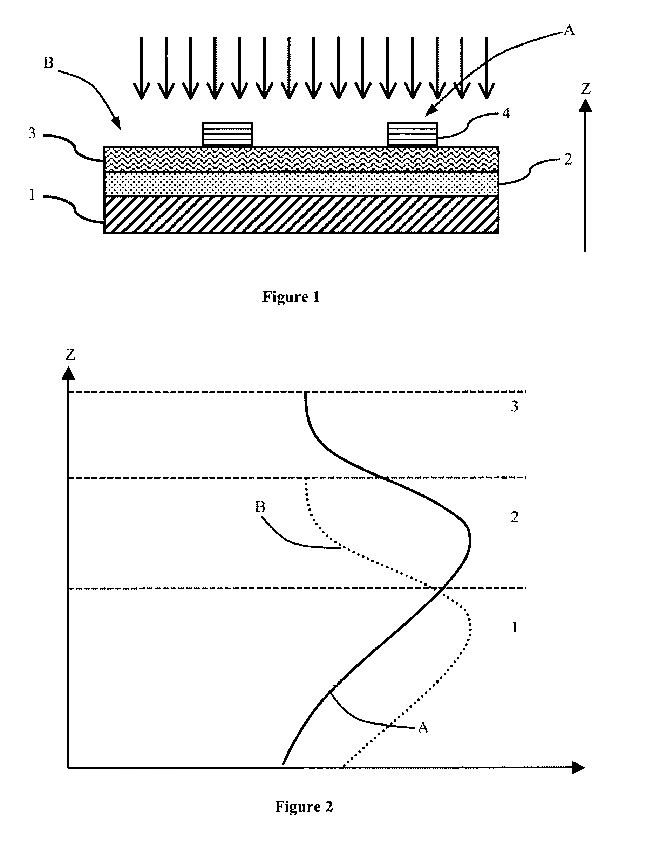

Comme illustré à la figure 1, de manière avantageuse, le support 1 est un substrat massif de silicium ce qui permet d'avoir un support 1 bon marché et compatible avec une très large gamme d'étapes technologiques. Cependant, selon les applications, il est possible de prévoir un autre type de matériau.

Le film électriquement isolant 2 permet d'isoler électriquement le support 1 et le film en matériau semi-conducteur 3. Le film électriquement isolant 2 peut être un film en oxyde de silicium, en nitrure de silicium, un empilement de ces deux films. Il est également envisageable d'utiliser d'autres matériaux électriquement isolants.

Le film en matériau semi-conducteur 3 est cristallin, c'est-à-dire monocristallin ou polycristallin. De manière avantageuse, le film en matériau semi-conducteur 3 est monocristallin afin de faciliter la réalisation de transistors à effet de champ performants et répétables. Le film en matériau semi-conducteur 3 comporte du silicium, typiquement au moins 99% de silicium, et avantageusement au moins une couche en silicium de manière à former un film en SiGe.

La couche 3 en silicium peut être dopée par des impuretés électriquement actives avant l'implantation des ions germanium. Les impuretés électriquement actives sont, par exemple, le bore, l'arsenic et le phosphore. Il est également possible de réaliser l'implantation des impuretés dopantes après l'implantation des ions germanium. L'implantation des impuretés électriquement actives peut également être réalisée après l'implantation du germanium.

La couche de protection 4 est disposée sur le film en matériau semi-conducteur 3. La couche de protection 4 peut être réalisée par tout matériau adapté. La couche de protection 4 est avantageusement réalisée par un matériau électriquement isolant, par exemple un oxyde de silicium, un nitrure de silicium, un matériau à plus forte constante diélectrique comme par exemple Al₂O₃, HfO₂ ou HfSiO₂. Cependant, il est également possible de déposer un matériau conducteur électriquement ou semi-conducteur.

La couche de protection 4 peut être formée par un film ou par une pluralité de films différents. Il est également possible de réaliser un empilement de plusieurs matériaux électriquement conducteurs ou isolants et éventuellement des matériaux semi-conducteurs. De manière avantageuse, la couche de protection 4 est homogène en composition et en épaisseur afin de faciliter l'obtention d'un alliage de silicium-germanium homogène.

De manière avantageuse, le matériau formant la couche de protection 4 peut être gravé sélectivement par rapport au matériau semi-conducteur formant le film 3.

Afin de former un film en SiGe, par exemple un canal en SiGe, c'est-à-dire une connexion semiconductrice entre une électrode de source et une électrode de drain, des ions de germanium sont implantés dans le film semi-conducteur. Les ions de germanium sont implantés à travers la couche de protection 4. Afin d'avoir un effet notable des ions germanium sur les performances électriques du transistor, il est nécessaire d'introduire une quantité importante d'ions dans le film semi-conducteur, typiquement quelques pourcents (en nombre). Selon la quantité d'ions germanium implantée, le pourcentage de germanium dans le film en silicium-germanium peut varier, par exemple, entre 1% et 50%, avantageusement entre 5% et 45%.

L'étape d'implantation réalisée sur le substrat permet d'introduire des atomes de germanium dans une ou plusieurs couches du substrat. L'implantation des atomes de germanium dans le film en matériau semi-conducteur 3, à travers le film de protection 4, modifie le profil de concentration dans le substrat et plus particulièrement dans le film en matériau semi-conducteur 3 en comparaison d'une implantation sans le film de protection 4.

De manière classique, les conditions d'implantation sont imposées d'une part par les performances techniques des équipements d'implantation et d'autre part par la quantité de germanium et par le profil de germanium recherchés dans le film en matériau semi-conducteur 3. L'énergie d'implantation définit la profondeur et le profil des dopants. Les conditions d'implantation sont choisies pour placer une concentration voulue en atomes de germanium à une épaisseur précise du substrat.

De manière classique, le film en matériau semi-conducteur 3 implanté en germanium est transformé en un film amorphe. Lorsque le substrat est un substrat massif, il existe toujours une partie profonde du substrat qui n'est pas modifiée ce qui autorise la recristallisation du film semi-conducteur à partir d'un germe cristallin. Il en est sensiblement de même lors de l'implantation dans un substrat de type semi-conducteur sur isolant partiellement déplété pour lequel l'épaisseur du film en matériau semi-conducteur 3 est importante.

Dans le cas des films minces en matériau semi-conducteur, toute l'épaisseur du film est amorphisée et il n'est plus possible de récupérer l'information cristalline perdue lors de l'implantation. Afin d'éviter que l'implantation ionique énergétique ne s'enfonce sur toute l'épaisseur de la couche 3 en matériau semi-conducteur, l'implantation est réalisée à travers la couche de protection 4.

Des simulations ont montré que pour des films 3 dont l'épaisseur est comprise entre 9 et 16nm, des implantations de germanium à 3keV, 4keV ou 5keV avec des doses d'implantation allant de 5.10¹⁵cm⁻² à 5.10¹⁶cm⁻² entrainent une amorphisation complète du film 3.

La couche de protection 4 permet artificiellement d'épaissir la couche 3 en matériau semi-conducteur. De cette manière, les ions de germanium ont une distance plus importante à parcourir ce qui permet de placer le maximum de la concentration en germanium dans la partie supérieure de la couche en matériau semi-conducteur 3. Un exemple de décalage du profil d'implantation est illustré à la figure 2 entre les zones A et B. La zone A correspond à une zone du film 3 recouverte par la couche de protection 4. La zone B correspond à une zone découverte.

Les ions de germanium sont implantés dans le film en matériau semi-conducteur 3 à travers la couche de protection 4 de manière à former une zone amorphisée en contact avec la couche de protection 4 et une zone cristalline en contact avec le film électriquement isolant. Après implantation, il y a superposition d'une zone amorphe et d'une zone cristalline dans le film 3.

Dans les conditions d'implantation citées plus haut, des simulations ont montré la présence d'une zone cristalline pour des films 3 ayant une épaisseur de 3nm, 4nm, 5nm, 6nm et 7nm au moyen d'une couche de protection 4 en oxyde de silicium ayant une épaisseur comprise entre 4 et 6nm. Des résultats concluants sont observés lorsque la couche de protection a une épaisseur comprise entre 4 et 10nm. Cette zone cristalline permet la recristallisation d'une éventuelle zone amorphe.

Comme cela est représenté à la figure 2, lors d'une implantation, la concentration en atomes de germanium (implantés sous la forme d'ions) suit un profil prédéfini dont la concentration maximale en atomes de germanium se trouve à la profondeur Rp. Cette profondeur est également appelée profondeur d'implantation moyenne Rp et elle est définie par l'énergie d'implantation et par le pouvoir d'arrêt des matériaux traversés. La répartition des atomes implantés selon l'axe Z peut être assimilée à une gaussienne dont le maximum de la concentration se trouve à la profondeur Rp. La courbe A illustre le profil d'implantation en atomes de germanium dans le substrat avec le film de protection 4. La courbe B illustre le profil d'implantation sans le film de protection 4, les conditions d'implantation sont identiques. Bien que la même quantité d'atomes de germanium soit envoyée en direction du substrat, une plus faible quantité de ces atomes est incorporée dans le film semi-conducteur 3 dans le cas de la courbe B en comparaison de ce qui est observé avec la courbe A.

La quantité d'ions implantés dans le substrat est fonction du temps d'implantation. L'implantation peut être réalisée par un implanteur classique ou par dopage plasma (plasma doping), même si le profil d'implantation est différent.

De manière générale, pour un film de silicium ayant une épaisseur inférieure à 10nm, l'énergie d'implantation est comprise entre 1keV et 10keV préférentiellement entre 2keV et 6keV. Dans ces conditions, l'épaisseur de la couche de protection 4 est comprise entre 2 et 10nm et préférentiellement entre 3 et 6nm. Dans cette configuration, le maximum de concentration du profil de germanium se trouve dans le film 3.

La dose implantée de germanium est comprise entre 1.10¹⁵cm⁻² et 5.10¹⁶cm⁻² et préférentiellement entre 5.10¹⁵cm⁻² et 5.10¹⁶cm⁻² et plus préférentiellement entre 5.10¹⁵cm-² et 1.10¹⁶cm⁻² de sorte que la concentration en germanium soit comprise entre 1 % et 50% selon les conditions indiquées plus haut.

Pour une implantation selon l'art antérieur, plus le film en matériau semi-conducteur 3 est mince et plus l'énergie utilisée doit être faible. Cependant, les performances techniques des équipements ne permettent pas de travailler en dessous d'une énergie limite ce qui impose une valeur minimale de la profondeur Rp atteignable par un équipement. En d'autres termes, lorsque le film en matériau semi-conducteur 3 est trop mince, l'étape d'implantation dope le support 1 au lieu du film en matériau semi-conducteur 3. Il n'est alors plus possible d'avoir un dopage important du film semi-conducteur sans augmenter le temps d'implantation et risquer l'amorphisation du film en matériau semi-conducteur. Si le film semi-conducteur 3 est amorphisé ses informations cristallines sont perdues et ses performances électriques sont grandement dégradées.

Dans un premier cas de figure, le procédé permet de doper efficacement une couche mince en matériau semi-conducteur, par exemple une couche ayant une épaisseur inférieure à 10nm et plus particulièrement une couche ayant une épaisseur inférieure à 8nm sans risquer une amorphisation complète du film 3. La couche de protection 4 est traversée en premier par les ions de germanium qui perdent une partie de leur énergie. Ensuite, ils s'enfoncent dans la couche en matériau semi-conducteur 3 et ils s'arrêtent dans la partie supérieure de la couche 3, c'est-à-dire dans la portion de la couche 3 en contact avec la couche de protection 4. La partie inférieure de la couche 3 est peu touchée par les ions de germanium et avec une énergie faible ce qui limite les risques d'amorphisation. Dans un mode de réalisation préférentielle, les conditions d'implantation et l'épaisseur de la couche de protection 4 sont choisies pour éviter l'amorphisation du tiers inférieur de la couche en matériau semi-conducteur 3. De bons résultats ont été obtenus pour un film en matériau semi-conducteur ayant une épaisseur comprise entre 3 et 8nm.

Dans un deuxième cas de figure, les capabilités techniques des équipements d'implantation ne permettent pas de délivrer un faisceau ionique de faible énergie compatible avec l'introduction des ions germanium dans une seule partie du film en matériau semi-conducteur 3. Dans ce cas de figure, l'utilisation de la couche de protection 4 permet d'augmenter la distance parcourue par les ions de germanium avant de s'arrêter dans le film en matériau semi-conducteur. Cette approche permet par exemple d'utiliser un équipement fortement énergétique pour doper un film mince qui nécessite un équipement faiblement énergétique. Le surplus d'énergie est perdu dans la couche de protection 4.

En d'autres termes, lorsque les capacités techniques de l'équipement d'implantation ne permettent pas de placer le maximum de la concentration en germanium à la profondeur voulue, il est intéressant de recouvrir le film en matériau semi-conducteur 3 par le film de protection 4 afin de déplacer la position de la concentration maximale en germanium à l'intérieur du film semi-conducteur. Le procédé permet d'assurer un dopage efficace du film semi-conducteur disposé à la surface du substrat bien que la profondeur moyenne d'implantation Rp minimale autorisée par l'équipement soit supérieure à l'épaisseur du film semi-conducteur 3.

Ce procédé présente un intérêt pour des films 3 en silicium dont l'épaisseur est inférieure à 10nm car ces films sont minces ce qui nécessite de faire fonctionner les équipements d'implantation dans une gamme de fonctionnement où les variabilités de fonctionnement sont plus importantes.

Ce procédé présente un intérêt encore plus important pour des films 3 en silicium dont l'épaisseur est inférieure à 8nm et particulièrement dans la gamme 4-8nm car ces films sont très minces ce qui nécessite de faire fonctionner les équipement d'implantation dans une gamme de fonctionnement où le faisceau ionique n'est pas stable. Certaines conditions d'implantation ne sont tout simplement pas disponibles actuellement avec les équipements présents sur le marché.

L'utilisation de la couche de protection 4 permet de faire fonctionner les équipements d'implantation dans des conditions de fonctionnement plus stables ce qui rend le procédé de fabrication plus robuste. Cela permet également de réaliser des transistors minces par implantation alors que les équipements adaptés ne sont pas encore présents sur le marché.

A titre d'exemple, pour une implantation à 3keV, le maximum de concentration du profil d'implantation se situe à 7nm de la surface du film 3 en l'absence de la couche 4. Le maximum de concentration du profil d'implantation se situe à moins de 0,5nm de l'interface entre le film 3 et la couche 4 lorsque cette dernière est formée par une couche d'oxyde de silicium ayant une épaisseur égale à 6nm. Le choix de l'épaisseur de la couche 4 permet de placer la position du maximum de concentration par rapport à la surface du film 3. Des résultats identiques ont été observés pour d'autres énergies d'implantation.

Comme indiqué plus haut, il est avantageux de former une couche de protection 4 homogène en épaisseur et en composition de sorte que le pouvoir d'arrêt de la couche 4 soit constant. De ce fait, le profil d'implantation est identique dans toutes les zones recouvertes uniquement par la couche de protection 4.

En variante, l'épaisseur et la composition de la couche de protection 4 permettent de définir la perte d'énergie des ions de germanium dans la couche de protection 4. Cela permet donc de définir l'énergie que posséderont les ions lorsqu'ils arriveront dans la couche en matériau semi-conducteur.

Afin de former des zones de silicium-germanium avec des concentrations en germanium différentes, il est avantageux de former une couche de protection 4 inhomogène. La couche de protection 4 peut présenter des épaisseurs différentes et/ou des compositions différentes. Ces inhomogénéités entrainent un décalage du profil d'implantation selon les zones. Ce décalage se traduit par des différences dans la quantité d'ions germanium incorporés et donc des décalages dans la concentration finale en germanium. Il devient donc facile de former des zones avec des concentrations différentes avec la même étape d'implantation.

L'utilisation d'une couche de protection 4 ayant un pouvoir d'arrêt variable selon différentes zones permet de moduler la profondeur d'implantation dans le substrat et donc la concentration finale de la zone implantée. De cette manière, il est possible de former des zones avec des concentrations différentes en atomes de germanium, par exemple une première zone avec une première concentration en germanium et une deuxième zone avec une deuxième concentration en germanium. Les deux zones sont décalées latéralement, c'est-à-dire selon une direction perpendiculaire à l'axe Z et correspondant à une première zone de la couche de protection 4 avec une première composition et/ou une première épaisseur différentes de la deuxième composition et/ou de la deuxième épaisseur d'une deuxième zone de la couche 4.

A titre d'exemple, pour une implantation de germanium à 4keV avec une dose de 1.10¹⁶cm⁻², la concentration en germanium varie entre 25% et 30% lorsque l'épaisseur de la couche de protection 4 en oxyde silicium varie entre 4 et 6nm. L'épaisseur du film 3 est constante et égale à 5nm. Ce comportement est également présent pour des énergies d'implantation plus élevées ou plus faibles et pour d'autres doses implantées.

De manière préférentielle, le substrat est complètement recouvert pour éviter la formation de zones amorphes dans le film 3.

De manière préférentielle, la profondeur d'implantation moyenne Rp est placée à l'intérieur du film semi-conducteur 3, de manière encore plus préférentielle au milieu du film semi-conducteur 3. De cette manière, le maximum de concentration est disposé dans le film semi-conducteur 3 ce qui permet de réduire la durée de l'étape d'implantation pour une quantité de dopants donnée et de réduire le risque d'amorphisation du film semi-conducteur 3. La profondeur d'implantation moyenne Rp peut être placée dans la couche 4.

Le fait de placer la profondeur d'implantation moyenne Rp au centre du film semi-conducteur 3 (selon l'axe Z) ou à proximité immédiate du centre du film semi-conducteur permet de rendre le procédé de dopage plus robuste. Une faible variation de l'épaisseur du film semi-conducteur 3 et/ou du film de protection 4 ne modifie pas beaucoup la quantité d'atomes de germanium qui est incorporée par unité de surface. De cette manière, une faible variation d'épaisseur du film 3 en silicium ne va pas modifier fortement la quantité d'atomes de germanium incorporés.

En d'autres termes, afin de faciliter l'implantation des atomes de germanium dans le film semi-conducteur, ce dernier est artificiellement épaissi au moyen du film de protection 4. Une partie des ions implantés est perdue car les ions se trouvent dans le film de protection 4, mais la quantité finale d'atomes de germanium incorporés dans le film semi-conducteur 3 est plus importante ou sensiblement identique en comparaison d'une implantation sans le film de protection 4 et l'énergie d'implantation est plus faible dans le film semi-conducteur se qui réduit les risques d'amorphisation.

Cette approche est d'autant plus intéressante que l'épaisseur du film semi-conducteur est fine par rapport au profil de dopant minimal (la valeur minimale de Rp) que l'équipement d'implantation est capable de fournir. Le procédé permet de rendre l'étape d'implantation moins sensible aux variations d'épaisseur et aux phénomènes d'amorphisation.

Alors que l'idée première est de chercher à réduire l'énergie d'implantation pour introduire le maximum de dopants dans le film semi-conducteur, dans le cas présent, un film de protection 4 est introduit, au moins lors de l'étape d'implantation, pour déplacer le maximum de la quantité d'atomes de germanium dans le volume du film semi-conducteur 3. Les limitations techniques de l'équipement d'implantation sont en partie compensées par l'utilisation du film de protection 4 qui peut être sacrificiel.

Une fois l'implantation réalisée, un recuit est effectué afin de réparer la zone implantée et placer les atomes de germanium dans des positions électriquement actives. Le recuit permet de former une zone en alliage de silicium-germanium avec une première concentration en germanium voire plusieurs zones avec des concentrations différentes.

La recristallisation du film 3 est réalisée à partir de la partie inférieure du film, c'est-à-dire la zone en contact avec le film électriquement isolant 2. La température de recuit est moins importante que pour un procédé de condensation de germanium ce qui permet de conserver un profil de germanium proche de celui défini par l'étape d'implantation. Cependant, il est possible d'augmenter le budget thermique du recuit afin d'accroitre la diffusion des atomes de germanium. A titre d'exemple un recuit à 600°C pendant 1 minute permet de recristalliser la zone amorphe. Un tel budget thermique permet par exemple de réaliser l'implantation de germanium après la formation des tranchées d'isolation voire après la définition de l'électrode de grille contrairement à un procédé de condensation du germanium qui nécessite industriellement des températures de recuit de l'ordre de 1050°C.

L'implantation des dopants dans le substrat pour former un plan de masse (ou ground plane en anglais), c'est-à-dire une contre-électrode peut être réalisée avant ou après le recuit de recristallisation. Le choix de l'enchainement de ces étapes peut être influencer la position de l'étape de réalisation des tranchées d'isolation. Les tranchées d'isolation permettent d'isoler électriquement les dispositifs à l'intérieur du substrat.

L'implantation et le recuit peuvent être configurés de manière à ce que la partie inférieure du film 3 soit plus pauvre en atomes de germanium voire que la partie inférieure du film 3 soit dépourvue d'atomes de germanium. Ce procédé permet de former, sur une épaisseur faible, un gradient de concentration en germanium qui autorise la formation d'une zone inférieure avec une faible teneur en atomes de germanium. La concentration minimale en germanium se situe à l'interface entre le film en matériau semi-conducteur 3 et le film électriquement isolant 2.

A titre d'exemple, une implantation de germanium avec une énergie de 3keV et une dose de 5.10¹⁵.cm⁻² peut être réalisée à travers une couche de protection de 5nm en oxyde de silicium. Pour un film de 7nm de silicium, le maximum de la concentration en germanium se situe à moins de 2nm de l'interface entre le film 3 et la couche de protection 4. Cette configuration permet de former une concentration maximale en germanium proche de 20% à l'interface avec le film 4 et inférieure à 1% à l'interface avec le film 2.

Dans un mode de réalisation particulier, l'implantation des ions de germanium est réalisée avant de graver le substrat pour former des tranchées d'isolation électrique et le remplissage de ces tranchées par un matériau électriquement isolant 2. Les tranchées d'isolation sont utilisées pour séparer électriquement les transistors à l'intérieur du film 3.

Dans ce cas de figure, la couche de protection 4 peut également être utilisée comme couche d'arrêt de gravure lors de l'étape de polissage mécano-chimique qui définit la position des tranchées d'isolation. Cependant, il est avantageux d'utiliser une couche plus épaisse déposée sur la couche de protection 4.

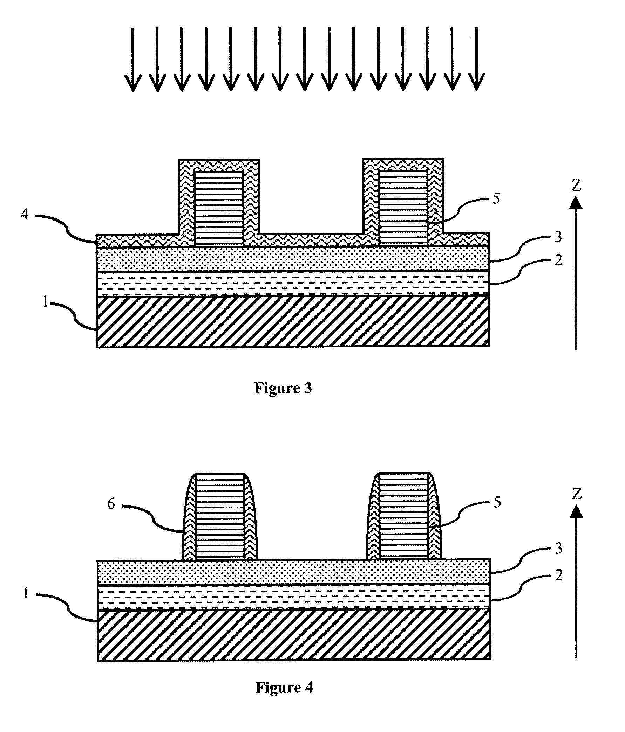

Dans un mode de réalisation particulier illustré à la figure 3, le film de protection 4 recouvre le film 3 et un motif de masquage 5. Il est également possible de prévoir que le motif de masquage 5 recouvre le film de protection 4. Le motif de masquage 5 est configuré pour empêcher l'introduction des ions de germanium dans la zone recouverte par le motif de masquage 5. Ce masquage de la surface du film 3 permet de former des zones en alliage de silicium-germanium à côté de zones en silicium. Le matériau formant le motif de masquage 5 est, par exemple une résine, mais d'autres matériaux sont envisageables comme un matériau diélectrique ou un polycristal. Il est également possible de former le motif de masquage 5 à coté de la couche de protection 4. Le motif de masquage 5 et la couche de protection 4 peuvent être formés par le même matériau mais ils présentent des épaisseurs différentes.

A la suite de l'implantation, une partie du film semi-conducteur 3 n'est pas amorphisée car une partie du film 3 n'a pas été atteinte par les atomes de germanium ou la quantité d'atomes de germanium pouvant atteindre l'interface avec le film en matériau électriquement isolant n'est pas suffisante pour entrainer l'amorphisation de toute l'épaisseur du film 3.

Comme l'information cristalline du film semi-conducteur a été conservée sur au moins la partie inférieure du film, il est possible d'effectuer un recuit thermique qui va guérir le film semi-conducteur implanté et former un alliage de silicium-germanium ayant des qualités électriques compatibles avec la formation d'un canal de transistor.

L'information cristalline perdue dans le zone amorphisée va être reproduite à partir de la zone non amorphisée donc cristalline. Selon les modes de réalisation, le film de protection 4 peut être conservé pour l'étape de recuit thermique ou éliminé avant l'étape de recuit thermique.

Dans un mode de réalisation particulier qui peut être combiné aux modes de réalisation précédents, le recuit thermique peut être configuré pour avoir une concentrations en germanium constante sur toute l'épaisseur du film semi-conducteur. Dans une variante de réalisation, le recuit thermique est configuré de manière à avoir un gradient de concentration en germanium sur l'épaisseur du film en matériau semi-conducteur. La zone la plus fortement dopée en germanium est la zone en contact avec le film de protection 4 et la concentration en germanium diminue au fur et à mesure que l'on s'éloigne du film de protection 4. Dans un mode de réalisation particulier, l'interface entre le film semi-conducteur et le film électriquement isolant 2 est dépourvue d'atomes de germanium, c'est-à-dire avec une concentration en atomes de germanium inférieure à 10²⁰ atomes/cm³.

En comparaison, d'une étape épitaxie, la concentration en germanium est plus homogène car les effets de charge sont réduits. Il est ensuite possible de former des zones en SiGe et des zones en silicium pur sans craindre les effets de charge de l'épitaxie sélective.

Dans un mode de réalisation particulier illustré à la figure 3, le motif de masquage 5 est formé par une électrode de grille. L'implantation de germanium est réalisée dans les électrodes de source/drain afin de modifier le matériau bordant le canal de conduction et introduire des contraintes dans le canal. Le paramètre de maille du silicium-germanium étant supérieur à celui du silicium, le canal est contraint en compression. De manière avantageuse illustrée à la figure 4, la couche de protection 4 est formée par le matériau définissant les espaceurs latéraux 6.

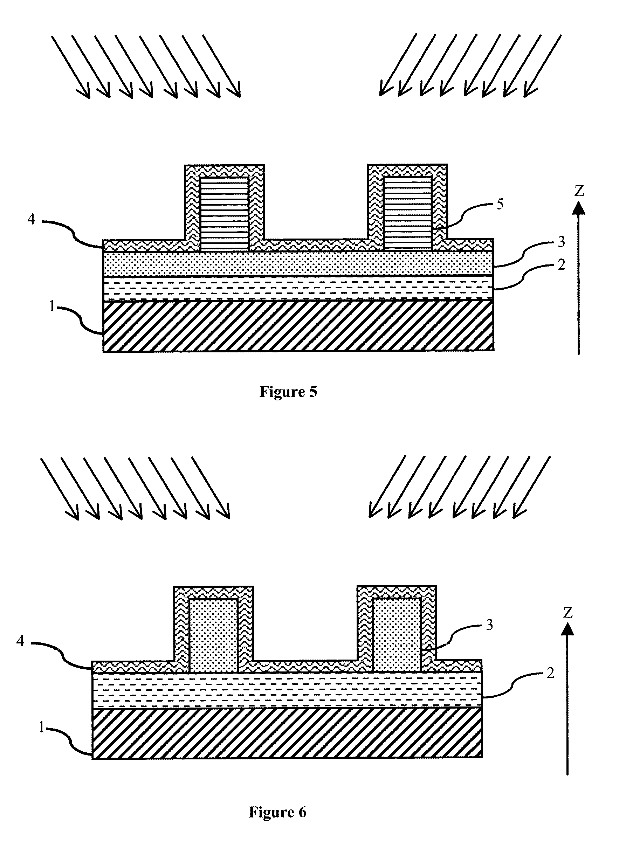

Dans un mode de réalisation particulièrement avantageux illustré à la figure 5, l'électrode de grille est formée sur le film 3 en matériau semi-conducteur. La couche de protection 4 est déposée sur le film 3 et sur l'électrode de grille 5. L'implantation des ions germanium est réalisée à travers la couche de protection au moyen d'une implantation tiltée, c'est-à-dire au moyen d'une implantation dont la trajectoire des ions germanium est décalée de plusieurs degrés par rapport à la perpendiculaire à la surface du substrat.

Cette implantation tiltée est particulièrement intéressante pour les transistors de petites dimensions car l'angle de tilt est réduit et les ions germanium sont en mesure d'atteindre toutes les régions du canal de conduction sans avoir besoin de diffuser lors du recuit d'activation.

Bien que les figures illustrent une implantation selon une architecture planaire, le procédé peut être utilisé pour doper des films en silicium selon des architectures tridimensionnelles. Dans cette configuration illustrée à la figure 6, les deux faces principales du film en matériau semi-conducteur 3 sont recouvertes par la couche de protection 4. L'épaisseur du film 3 correspond à la dimension la plus faible du motif ou de la couche, ici l'épaisseur est mesurée perpendiculairement à la direction Z

Dans un mode de réalisation particulier qui peut être combiné avec les précédents, il est avantageux de réaliser plusieurs étapes d'implantation de germanium en utilisant plusieurs énergies d'implantation afin de former un profil particulier de germanium dans le film 3. Il est également possible de jouer sur les angles d'implantation entre les différentes implantations et/ou sur la couche de protection afin de former un profil particulièrement avantageux de germanium.

Le procédé d'implantation a donné de très bons résultats dans les conditions suivantes. L'épaisseur du film en matériau semi-conducteur est comprise entre 3 et 8nm. L'épaisseur du film de protection est comprise entre 4nm et 10nm notamment si ce dernier est en oxyde de silicium, nitrure de silicium, oxyde d'hafnium, oxyde de silicium et d'hafnium ou un empilement de ces derniers. L'énergie d'implantation est comprise entre 2keV et 6keV. La dose de dopants est comprise entre 5.10¹⁴ et 5.10¹⁶cm⁻² par exemple pour les impuretés dopantes classiques, notamment le bore, le phosphore et l'arsenic.

Ces conditions spécifiques permettent de former facilement un film en alliage de silicium-germanium par implantation ionique même lorsque l'épaisseur initiale du matériau semi-conducteur est faible, c'est-à-dire inférieur à 8nm.

Le procédé peut alors être dépourvu d'une étape de condensation de germanium, c'est-à-dire d'une étape d'oxydation du film semi-conducteur implanté pour former un matériau plus riche en germanium.

## Revendications

1. Procédé de réalisation d'un transistor à effet de champ comportant successivement:
- prévoir un substrat de type semi-conducteur sur isolant comportant successivement : un support (1), un film électriquement isolant (2), un film cristallin (3) en matériau semi-conducteur, une couche de protection (4), dans lequel le film en matériau semi-conducteur (3) a une épaisseur comprise entre 4 et 8nm,
- implanter des ions de germanium dans le film en matériau semi-conducteur (3) à travers la couche de protection (4) de manière à former une zone amorphisée en contact avec la couche de protection (4) superposée à une zone cristalline en contact avec le film électriquement isolant (2),
- recuire le film en matériau semi-conducteur (3) de manière à recristalliser la zone amorphisée à partir de la zone cristalline et former une zone en alliage de silicium-germanium avec une première concentration en germanium.

2. Procédé selon la revendication 1, **caractérisé en ce que** la quantité d'ions de germanium est configurée de manière à former un film en matériau semi-conducteur (3) comportant entre 5% et 45% de germanium.

3. Procédé selon l'une des revendications 1 et 2, **caractérisé en ce que** le film cristallin (3) en matériau semi-conducteur est recouvert par un motif de masquage (5) configuré pour empêcher l'introduction des ions de germanium dans la zone recouverte par le motif de masquage (5).

4. Procédé selon l'une quelconque des revendications 1 à 3, **caractérisé en ce que** la couche de protection (4) comporte une première zone avec une première composition et/ou une première épaisseur différentes de la deuxième composition et/ou de la deuxième épaisseur d'une deuxième zone, l'implantation forme une première zone en alliage de silicium-germanium avec la première concentration en germanium première zone et une deuxième zone avec une deuxième concentration en germanium différente de la première concentration.

5. Procédé selon l'une quelconque des revendications 1 à 4, **caractérisé en ce que** après avoir formé une électrode de grille, l'implantation des ions de germanium est réalisée avec un angle de tilt configuré pour former un canal de conduction en silicium-germanium.

6. Procédé selon l'une quelconque des revendications 1 à 4, **caractérisé en ce que**, après avoir formé une électrode de grille (5), l'implantation des ions de germanium est réalisée de manière à former des électrodes de source et drain en alliage de silicium-germanium et un canal de conduction en silicium.

7. Procédé selon l'une quelconque des revendications 1 à 6, **caractérisé en ce que** l'épaisseur du film cristallin (3) en matériau semi-conducteur est comprise entre 3 et 8nm, l'épaisseur de la couche de protection (4) est comprise entre 4 et 10nm, l'énergie d'implantation est comprise entre 2kevV et 6keV et la dose implantée est comprise entre 5.10¹⁴ et 5.10¹⁶cm⁻².
